(19) Europäisches Patentamt

European Patent Office

Office européen des brevets

(11) EP 0 571 747 B1

(12) **EUROPÄISCHE PATENTSCHRIFT**

(45) Veröffentlichungstag und Bekanntmachung des Hinweises auf die Patenterteilung:
06.10.1999 Patentblatt 1999/40

(51) Int Cl.6: **H03G 5/14**, H03G 3/20, H04B 10/14

(21) Anmeldenummer: 93105652.7

(22) Anmeldetag: 06.04.1993

(54) **Schaltungsanordnung für einen optischen Empfänger**

Circuit arrangement for an optical receiver

Circuit pour un récepteur optique

(84) Benannte Vertragsstaaten:
**DE FR GB IT**

(30) Priorität: **18.04.1992 DE 4212933**

(43) Veröffentlichungstag der Anmeldung:
**01.12.1993 Patentblatt 1993/48**

(73) Patentinhaber: **ALCATEL**
**75008 Paris (FR)**

(72) Erfinder: **Jung, Reinhold**
**W-7030 Böblingen (DE)**

(74) Vertreter: **Knecht, Ulrich Karl, Dipl.-Ing. et al**
**Alcatel**
**Intellectual Property Department, Stuttgart**
**Postfach 30 09 29**
**70449 Stuttgart (DE)**

(56) Entgegenhaltungen:
GB-A- 2 178 919          GB-A- 2 198 002
US-A- 4 757 192

• PATENT ABSTRACTS OF JAPAN vol. 16, no. 88 (E-1173) 4. März 1992 & JP-A-03 270 504 (FUJITSU LTD.) 2. Dezember 1991

## Beschreibung

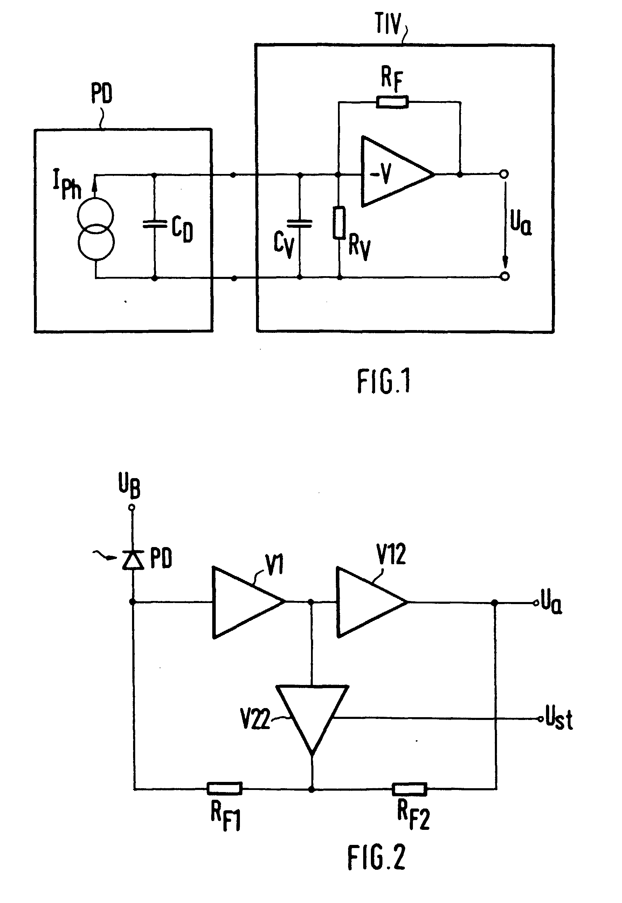

Die Erfindung betrifft eine Schaltungsanordnung für einen optischen Empfänger, der in optischen Nachrichtenübertragungssystemen als opto-elektrischer Wandler dient. Derartige optische Empfänger bestehen aus einer Photodiode und einem Vorverstärker. Wenn hohe Bandbreite und großer Dynamikbereich gefordert werden, wird häufig als Vorverstärker ein Transimpendanzverstärker eingesetzt, vgl. Dieter Lutzke: Lichtwellenleiter-Technik, München: Pflaum 1986, Seite 282 bis 289. In Fig. 1 ist ein allgemein bekanntes Ersatzschaltbild eines optischen Empfängers dargestellt. Die Photodiode PD ist als Stromquelle $I_{Ph}$ mit parallel geschalteter Kapazität $C_D$ dargestellt, der nachgeschaltete Transimpedanzverstärker TIV besteht im Ersatzschaltbild aus einem Operationsverstärker V mit Gegenkopplungswiderstand $R_F$ und dem Eingangswiderstand $R_V$ sowie der Eingangskapazität $C_V$ des Operationsverstärkers. Die Photodiode PD liefert einen Photostrom $I_{Ph}$, der in erster Näherung proportional zur empfangenen Lichtleistung ist. Der über den Gegenkopplungswiderstand $R_F$ rückgekoppelte Operationsverstärker formt den Photostrom $I_{Ph}$ in eine Ausgangsspannung $U_a$ um. Die entsprechende Strom-Spannungs-Übertragungsfunktion des Transimpedanzverstärkers lautet unter der Voraussetzung großer Verstärkung v

$$H(\omega) = \frac{Ua(\omega)}{I_{ph}(\omega)} = - \frac{R_F}{1 + j\omega \dfrac{R_F\,(C_D + C_V)}{v}}$$

Daraus ergibt sich die 3 dB-Grenzfrequenz zu

$$fg = \frac{v}{2\pi\,R_F\,(C_D + C_V)}$$

Durch Vorgabe einer gewünschten Bandbreite wird somit der Gegenkopplungswiderstand $R_F$ festgelegt. Der Widerstandswert hat aber einen Einfluß auf die Rauscheigenschaften und damit auf die Empfängerempfindlichkeit. Um die Empfängerempfindlichkeit groß zu machen, muß der Gegenkopplungswiderstand $R_F$ möglichst groß gewählt werden. Dadurch vermindert sich zwar der Rauschbeitrag des Gegenkopplungswiderstandes $R_F$, gleichzeitig verringert sich aber die Bandbreite des optischen Empfängers.

Bei bekannten Lösungen wird der Wert des Gegenkopplungswiderstandes nach der höchsten geforderten Übertragungsgeschwindigkeit in einem optischen Nachrichtenübertragungssystem bemessen, vgl. R.G. Meyer, R.A. Blauschild: "A Wide-Band Low-Noise Monolithic Transimpedance Amplifier", IEEE Journal of Solid-State Circuits, Vol. SC-21, No. 4, August 1986. Wird ein solcher Empfänger jedoch bei einer niedrigeren Übertragungsgeschwindigkeit eingesetzt, so ergibt sich aufgrund des nicht angepaßten Gegenkopplungswiderstandes ein Verlust an Empfängerempfindlichkeit.

Der Erfindung liegt nun die Aufgabe zugrunde, eine Schaltungsanordnung für einen optischen Empfänger anzugeben, die universell für unterschiedliche Übertragungsgeschwindigkeiten einsetzbar ist und als monolithisch integrierte Schaltung realisierbar sein soll.

Diese Aufgabe wird durch die im Anspruch 1 beschriebene Schaltungsanordnung gelöst. Durch die Aufteilung des Gegenkopplungswiderstandes in eine Reihenschaltung zweier Widerstände wird es möglich, die Größe des wirksamen Gegenkopplungswiderstandes der jeweiligen Übertragungsgeschwindigkeit anzupassen. Großer Gegenkopplungswiderstand bedingt niedrige Grenzfrequenz, beziehungsweise geringe Bandbreite, kleiner Gegenkopplungswiderstand bedingt hohe Grenzfrequenz beziehungsweise größere Bandbreite. Es ist möglich, den Gegenkopplungswiderstand auch in mehr als zwei Widerstände aufzuteilen und damit eine Optimierung des Transimpedanzverstärkers für die Übertragung unterschiedlicher Bitraten zu erreichen.

Die Wirkung der Schaltungsanordnung beruht darauf, daß der ersten Verstärkerstufe zwei gleichwirkende und eingangsseitig parallel geschaltete Verstärkerstufen nachgeschaltet sind, von denen eine steuerbar ist. Die Ausgänge der beiden Verstärkerstufen liegen an den Anschlüssen eines Teilwiderstandes des Gegenkopplungswiderstandes, so daß bei gleichem Übertragungsverhalten der Verstärker am Teilwiderstand keine Spannungsdifferenz entsteht und somit der Teilwiderstand für die Gegenkopplung wirkungslos ist. Wird nun durch die Steuerspannung die Verstärkerstufe gesperrt, deren Ausgang an den Verbindungspunkt der beiden Teilwiderstände geschaltet ist, so wird der gesamte Gegenkopplungswiderstand wirksam.

Somit wird ein monolithisch integrierbarer optischer Empfänger angegeben, der beispielsweise in einer Breitbandteilnehmeranschluß-Schnittstelle angepaßt sowohl bei einer Übertragungsrate 150 Mbit/s als auch bei einer Übertragungsrate 600 Mbit/s betrieben werden kann.

Die Erfindung wird nachstehend an einem Ausführungsbeispiel erläutert. In der dazugehörigen Zeichnung zeigen

Fig. 1  ein Ersatzschaltbild eines optischen Empfängers gemäß dem Stand der Technik,

Fig. 2  ein Blockschaltbild der erfindungsgemäßen Schaltungsanordnung,

Fig. 3  ein Schaltbild der erfindungsgemäßen Schaltungsanordnung,

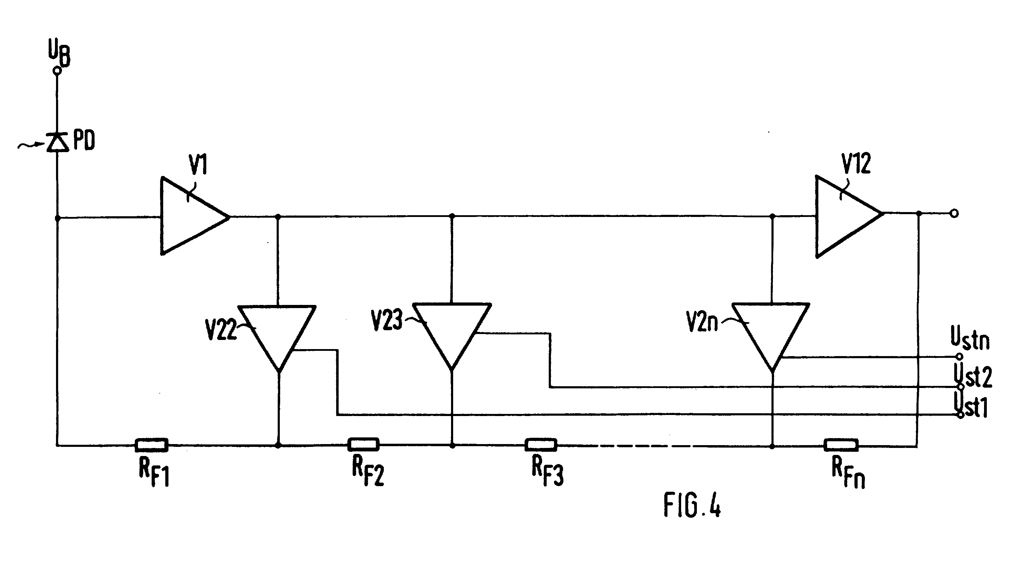

Fig. 4  ein Blockschaltbild der erfindungsgemäßen Schaltungsanordnung mit mehreren Teilwiderständen.

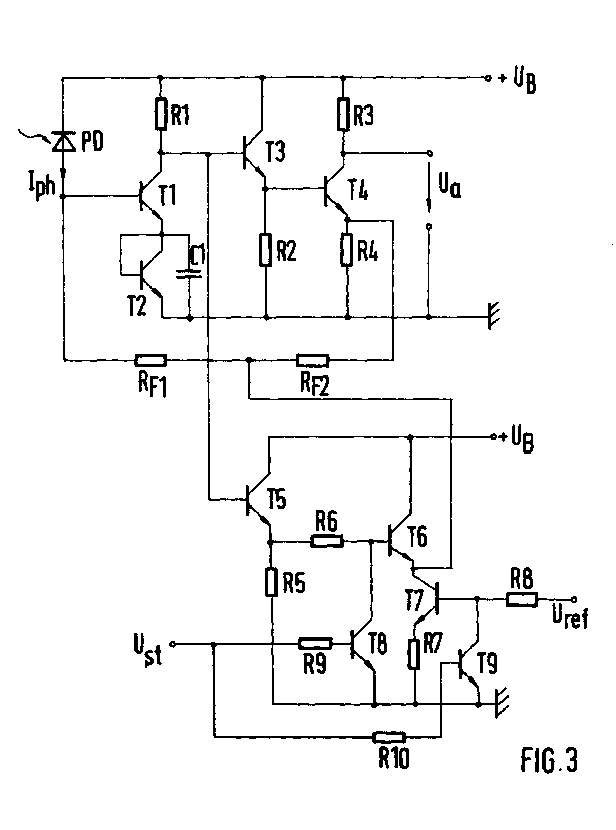

Gemäß Fig. 2 besteht die Schaltungsanordnung für einen optischen Empfänger aus einer Photodiode PD, einem Verstärker aus zwei Verstärkerstufen V1, V12, einem weiteren Verstärker V22, dessen Arbeitsweise durch eine Steuerspannung $U_{st}$ bestimmt wird und einem als Reihenschaltung zweier Widerstände $R_{F1}$, $R_{F2}$ ausgeführten Gegenkopplungswiderstand. Eine technische Ausführungsmöglichkeit zeigt Fig. 3. Danach enthält die erste Verstärkerstufe V1 als aktives Element einen ersten Transistor T1, die zweite Verstärkerstufe V12 enthält zwei Transistorstufen mit einem zweiten und dritten Transistor T3, T4. In gleicher Weise ist ein zweiter Signalpfad als ein weiterer Verstärker V22 mit zwei Transistoren T5, T6 aufgebaut. Eine Zusatzschaltung aus zwei Transistorschaltern mit den Transistoren T8, T9 ermöglicht die Steuerung dieses zweiten Signalweges. Weiterhin ist eine von einer Referenzspannung $U_{ref}$ gesteuerte Stromquelle mit einem Transistor T7 vorgesehen.

Die Wirkungsweise der Schaltungsanordnung ist folgende: Für den Fall, daß die Steuerspannung $U_{st}$ größer ist als die Basis-Emitter-Spannung $U_{BE}$ der zwei Transistoren T8, T9 der Zusatzschaltung, werden die Transistoren T8, T9 bis zur Kollektor-Emitter-Sättigungsspannung $U_{CEsat}$ durchgesteuert. Der zweite Signalpfad ist dadurch über einen Widerstand R6 und den Transistor T8 nach Masse kurzgeschlossen. Gleichzeitig wird die Referenzspannung $U_{ref}$, die mittels der Schaltung aus Transistor T7 und Widerstand R7 einen Konstantstrom durch den Transistor T6 erzeugt, über einen Widerstand R8 und den Transistor T9 ebenfalls nach Masse kurzgeschlossen. Der Transistor T6 im Ausgang des zweiten Signalpfades ist damit stromlos und an seiner Basis-Emitter-Diode liegt eine Sperrspannung von etwa 2 $U_{BE}$ an. Das hat zur Folge, daß am Verbindungspunkt zwischen den beiden Teilwiderständen $R_{F1}$, $R_{F2}$ des Gegenkopplungswiderstandes nur die relativ geringe Sperrschichtkapazität der Basis-Emitter-Diode des Transistors T6 wirksam ist, die jedoch auf die Übertragungsfunktion und auf das Rauschen des Transimpedanzverstärkers praktisch keinen Einfluß hat. Der Transimpedanzverstärker arbeitet nun mit einem wirksamen Gegenkopplungswiderstand, der sich aus der Summe der beiden Teilwiderstände $R_{F1}$, $R_{F2}$ ergibt.

Ist die Steuerspannung sehr viel kleiner als die Basis-Emitter-Spannung $U_{BE}$ der Transistoren T8, T9 der Zusatzschaltung, so werden die Transistoren T8, T9 gesperrt und der Transistor T6 im Ausgang des zweiten Signalpfades wird von einem Konstantstrom durchflossen. Das am Kollektor des Transistors T1 der ersten Verstärkerstufe abgegriffene Signal wird über den zweiten Signalpfad mit den Transistoren T5, T6 und dem ersten Teilwiderstand $R_{F1}$ des Gegenkopplungszweiges auf den Eingang des Transimpedanzverstärkers gegengekoppelt. Da an den Emitter der Ausgangstransistoren T4, T6 im ersten und zweiten Signalpfad jeweils das gleiche Signal liegt und zwischen beiden der zweite Teilwiderstand $R_{F2}$ des Gegenkopplungswiderstandes geschaltet ist, so ist die Gegenkopplung durch den zweiten Teilwiderstand $R_{F2}$ wirkungslos. Der Transimpedanzverstärker arbeitet nun nur mit dem ersten Teilwiderstand $R_{F1}$ als Gegenkopplungswiderstand.

**Patentansprüche**

1. Schaltungsanordnung für einen optischen Empfänger, die eine Photodiode (PD) und einen Transimpedanzverstärker (TIV) enthält wobei die Photodiode (PD) zwischen Versorgungsspannungsquelle ($U_B$) und Eingang des Transimpedanzverstärkers (TIV) oder Eingang des Transimpedanzverstärkers (TIV) und Masse liegt und der Transimpedanzverstärker (TIV) aus einer ersten Verstärkerstufe (V1) und mindestens einer zweiten Verstärkerstufe (V12) besteht und einen Gegenkopplungswiderstand enthält,
   **dadurch gekennzeichnet,** daß der Gegenkopplungswiderstand als Reihenschaltung zweier Widerstände ($R_{F1}$, $R_{F2}$) zwischen Eingang und Ausgang des Transimpedanzverstärkers (TIV) liegt und daß zwischen dem Verbindungspunkt von erster und zweiter Verstärkerstufe (V1, V12) und dem Verbindungspunkt der beiden Gegenkopplungswiderstände ($R_{F1}$, $R_{F2}$) ein Verstärker (V22) geschaltet ist, der im wesentlichen die gleiche Übertragungsfunktion hat wie die zweite Verstärkerstufe (V12) und der Mittel enthält, mit denen der Verstärker (V22) in einen aktiven oder einen gesperrten Zustand geschaltet wird.

2. Schaltungsanordnung für einen optischen Empfänger nach Anspruch 1, dadurch gekennzeichnet, daß der Gegenkopplungswiderstand als Reihenschaltung von mehr als zwei Widerständen gebildet wird, wobei mit jedem weiteren Teilwiderstand ($R_{F3}$, $R_{Fn}$) der Transimpedanzverstärker um einen der zweiten Verstärkerstufe (V12) eingangsseitig parallel geschalteten Verstärker (V23, V2n) erweitert wird, wobei dieser im wesentlichen die gleiche Übertragungsfunktion hat wie die zweite Verstärkerstufe (V12) und daß der Ausgang des parallel geschalteten Verstärkers (V23, V2n) an den Verbindungspunkt von vorletztem ($R_{Fn-1}$) und letztem ($R_{Fn}$) Teilwiderstand geschaltet ist und jeder dieser Verstärker (V23, V2n) unabhängig voneinander aktiviert wird.

3. Schaltungsanordnung für einen optischen Empfänger nach den Ansprüchen 1 und 2, dadurch gekennzeichnet, daß der zwischen den Verstärkerstufen und den Teilwiderständen des Gegenkopplungszweiges liegende Verstärker über eine Steuerschaltung mit einer Steuerspannung ($U_{st}$) so ge-

schaltet wird, daß im ersten Zustand die Eingangsspannung des Verstärkers unwirksam ist, beispielsweise durch einen von einer Transitorstufe (T8) bewirkten Kurzschluß gegen Masse, und daß in einem zweiten Zustand der Verstärker in gleicher Weise wie die letzte Verstärkerstufe arbeitet, so daß an den beiden Anschlüssen des entsprechenden Teilwiderstandes die gleiche Spannung liegt und damit der Teilwiderstand stromlos und für die Gegenkopplung wirkungslos ist.

## Claims

1. A circuit arrangement for an optical receiver comprising a photodiode (PD) and a transimpedance amplifier (TIV), with the photodiode (PD) connected between a supply voltage source ($U_B$) and an input of the transimpedance amplifier (TIV) or between the input of the transimpedance amplifier (TIV) and ground, and the transimpedance amplifier (TIV) comprising a first amplifier stage (V1), at least a second amplifier stage (V12), and a negative-feedback resistor, **characterized in** that the negative-feedback resistor is connected as a series combination of two resistors ($R_{F1}$, $R_{F2}$) between the input and output of the transimpedance amplifier (TIV), and that between the junction of the first and second amplifier stages (V1, V12) and the junction of the two feedback resistors ($R_{F1}$, $R_{F2}$), an amplifier (V22) is inserted which has essentially the same transfer function as the second amplifier stage (V12) and includes means for switching the amplifier (V22) to an active state or a blocked state.

2. A circuit arrangement as claimed in claim 1, characterized in that the negative-feedback resistor is formed by a series combination of more than two resistors, with the transimpedance amplifier being expanded for each additional resistor ($R_{F3}$, $R_{Fn}$) by addition of an amplifier (V23, V2n) connected at the input end in parallel with, and having essentially the same transfer function as, the second amplifier stage (V12), that the output of the parallel-connected amplifier (V23, V2n) is connected to the junction of the next to the last ($R_{Fn-1}$) and last ($R_{Fn}$) resistors, and that said amplifiers (V23, V2n) are activated independently of each other.

3. A circuit arrangement as claimed in claims 1 and 2, characterized in that the amplifier connected between the junction of the amplifier stages and the junction of the resistors of the negative-feedback path is switched with a control voltage ($U_{st}$) via a control circuit in such a way that in a first state, the input voltage of the amplifier is ineffective, e.g., due to a short circuit to ground caused by a transistor stage (T8), and that in a second state, the amplifier operates in the same way as the last amplifier stage, so that the same voltage is applied at the two terminals of the associated resistor, which is thus currentless and has no effect on the negative feedback.

## Revendications

1. Circuit pour un récepteur optique, comprenant une photodiode (PD) et un amplificateur à transimpédance (TIV), la photodiode (PD) étant située entre la source de tension d'alimentation ($U_B$) et l'entrée de l'amplificateur à transimpédance (TIV) ou entre l'entrée de l'amplificiateur à transimpédance (TIV) et la masse, et l'amplificateur à transimpédance (TIV) est constitué par un premier étage d'amplification (V1) et au moins un deuxième étage d'amplification (V12) et contient une résistance de rétroaction,
caractérisé en ce que la résistance de rétroaction, constituée par le branchement en série de deux résistances ($R_{F1}$, $R_{F2}$), est située entre l'entrée et la sortie de l'amplificateur à transimpédance (TIV) et en ce qu'un amplificateur (V22) est branché entre le point de liaison du premier et du deuxième étage d'amplification (V1, V12) et le point de liaison des deux résistances de rétroaction ($R_{F1}$, $R_{F2}$), lequel amplificateur exerce sensiblement la même fonction de transmission que le deuxième étage de transmission (V12) et contient des moyens par lesquels l'amplificateur (V22) est branché en mode actif ou en mode bloqué.

2. Circuit pour un récepteur optique selon la revendication 1, caractérisé en ce que l'amplificateur à transimpédance est constitué par le branchement en série de plus de deux résistances, chaque résistance secondaire ($R_{F3}$, $R_{Fn}$) de la résistance à transimpédance agrandissant le dispositif par un amplificateur (V23, V2n) branché en parallèle du côté de l'entrée du deuxième étage d'amplification (V12), ledit amplificateur exerçant la fonction de transmission identique à celle du deuxième étage d'amplification (V12), et en ce que la sortie de l'amplificateur (V23, V2n), branché en parallèle, est branchée au niveau du point de liaison de l'avant-dernière ($R_{Fn-1}$) et de la dernière ($R_{Fn}$) résistance secondaire et ces amplificateurs (V23, V2n) sont activés chacun indépendamment de l'autre.

3. Circuit pour un récepteur optique selon les revendications 1 et 2, caractérisé en ce que l'amplificateur, situé entre les étages d'amplification et les résistances secondaires de la branche de rétroaction, est branché par l'intermédiaire d'un circuit de commande à une tension de commande ($U_{st}$), de telle sorte que dans le premier état, la tension d'entrée de l'amplificateur est inactive, par exemple par un court-circuit contre la masse provoqué par l'un des niveaux du transistor (T8), et en ce que dans un deuxième état, l'amplificateur fonctionne de la même manière que le dernier étage d'amplification, de telle sorte que la même tension apparaît au niveau des deux connexions de la résistance secondaire correspondante et que, de ce fait, la résistance secondaire est sans courant et n'exerce aucune action sur la rétroaction.

FIG.1

FIG.2

FIG.3

FIG.4

EP 0 571 747 B1